Europäisches Patentamt

European Patent Office

Office européen des brevets

(19)

(11) Numéro de publication : **0 055 175**
**B1**

(12) **FASCICULE DE BREVET EUROPÉEN**

(45) Date de publication du fascicule du brevet :
**13.06.84**

(21) Numéro de dépôt : **81402014.5**

(22) Date de dépôt : **16.12.81**

(51) Int. Cl.³ : **F 25 B 21/02, H 01 L 35/30**

(54) **Installations thermo-électriques.**

(30) Priorité : **23.12.80 FR 8027374**
**03.12.81 FR 8122636**

(43) Date de publication de la demande :
**30.06.82 Bulletin 82/26**

(45) Mention de la délivrance du brevet :
**13.06.84 Bulletin 84/24**

(84) Etats contractants désignés :
**AT BE CH DE GB IT LI LU NL SE**

(56) Documents cités :
**FR-A- 1 430 425**
**FR-A- 1 441 300**
**FR-A- 1 547 908**
**FR-A- 2 315 771**
**FR-A- 2 419 479**
**GB-A- 1 312 457**
**US-A- 3 178 895**
**US-A- 3 209 547**
**US-A- 3 360 942**
**US-A- 3 626 704**

(73) Titulaire : **AIR INDUSTRIE**
**19-21 avenue Dubonnet**
**F-92401 Courbevoie (FR)**

(72) Inventeur : **Buffet, Jean**
**2, avenue Dode de la Brunerie**
**F-75016 Paris (FR)**

(74) Mandataire : **Jacquelin, Marc-Henri et al**
**Cabinet PLASSERAUD 84, rue d'Amsterdam**
**F-75009 Paris (FR)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

Jouve, 18, rue St-Denis, 75001 Paris, France

## Description

L'invention est relative, d'une façon générale, aux installations thermo-électriques comportant des thermo-éléments montés entre deux parois d'échanges thermiques, à savoir une paroi chaude et une paroi froide.

De telles installations peuvent être utilisées pour engendrer un courant électrique continu lorsque les parois chaude et froide sont maintenues à des températures différentes ou, au contraire, pour extraire de la chaleur d'une paroi appelée « paroi froide » et en évacuer par une paroi appelée « paroi chaude », lorsqu'un courant électrique continu circule dans les thermo-éléments.

L'invention s'applique plus particulièrement, mais non exclusivement, aux installations de ce dernier type, les thermo-éléments étant alimentés en courant électrique continu pour extraire de la chaleur d'une paroi froide et en évacuer par une paroi chaude. Une telle installation, appelée « pompe à chaleur », peut être utilisée pour produire « du chaud » ou « du froid ». En effet, les thermo-éléments sont de deux types, à savoir les thermo-éléments de type P qui transfèrent des calories dans le sens du courant, et les thermo-éléments du type N qui transfèrent des calories dans le sens inverse du courant.

Pour réaliser de telles installations, on a déjà proposé de faire coopérer chaque paroi, chaude ou froide, avec un tube chaud ou froid dans lequel circule un fluide chaud.

C'est ainsi que l'on connaît des installations thermo-électriques comportant :

— un premier réseau de tubes chauds parallèles et dans lesquels circule un fluide chaud,

— un second réseau de tubes froids parallèles, disposés parallèlement aux tubes chauds du premier réseau, et dans lesquels circule un fluide froid.

Les thermo-éléments sont alors montés, généralement avec interposition d'une paroi chaude et d'une paroi froide, entre les susdits tubes chauds et les susdits tubes froids.

Dans une installation de ce type, on prévoit des moyens de liaison mécanique pour maintenir entre eux les premier et second réseaux de tubes chauds et froids, et pour créer une force d'application entre les susdits tubes chauds et froids et les susdits thermo-éléments.

Jusqu'à ce jour, les moyens de liaison mécanique connus faisaient appel à des solutions qui étaient plus ou moins complexes à réaliser, qui provoquaient des pertes de charge pour le fluide, qui posaient des problèmes d'étanchéité, qui introduisaient des résistances thermiques de contact au niveau des thermo-éléments, et qui ne présentaient pas une assez grande fiabilité de fonctionnement.

Parmi ces solutions, on peut citer les suivantes :

— on prévoyait de disposer, transversalement aux tubes chauds et froids, des tiges assurant une force d'application entre les susdits tubes chauds et froids et les susdits thermo-éléments (inconvénient de compliquer l'installation par une multiplicité de structures mécaniques à l'intérieur des deux réseaux de tubes chauds et froids) ;

— on prévoyait des tubes formés par une succession de tronçons rigides et de soufflets déformables susceptibles d'absorber les déformations dues aux variations de température (inconvénient de nécessiter des liaisons étanches entre chaque tronçon rigide et chaque soufflet déformable, de présenter des risques de fuite, d'engendrer des pertes de charge pour le fluide) ;

— on prévoyait de maintenir les thermo-éléments dans une carcasse rigide isolée thermiquement par rapport aux tubes et d'interposer, entre les thermo-éléments et les tubes, des contacts glissants permettant des déplacements relatifs entre chaque thermo-élément et chaque tube (inconvénient de provoquer une résistance thermique qui, de plus, risque d'augmenter pendant la durée d'utilisation de l'installation, et inconvénient d'être d'une réalisation complexe et coûteuse).

L'invention a précisément pour but de prévoir des moyens de liaison mécanique qui ne présentent pas les inconvénients rappelés ci-dessus à propos des solutions connues.

Selon l'invention, les moyens de liaison mécanique permettent :

— de réaliser une installation simple dans laquelle l'espace intérieur occupé par les deux réseaux de tubes chauds et froids est libre de toute structure mécanique interne,

— de conserver une continuité des tubes chauds et froids sans avoir recours à des tronçons de natures mécaniques différentes, donc d'éviter toute liaison étanche, d'éliminer les risques de fuite et de diminuer au maximum les pertes de charge pour le fluide,

— d'obtenir des résistances thermiques faibles et constantes dans le temps,

— de diminuer le prix de revient en permettant une construction et un montage simples et peu coûteux (construction par couches de tubes de même température et montage par empilage de tubes identiques).

Selon l'invention, l'installation comporte :

— un premier réseau de tubes chauds s'étendant entre deux extrémités, disposés de façon parallèle, et dans lesquels circule un fluide chaud,

— un second réseau de tubes froids, s'étendant entre deux extrémités, disposés de façon parallèle et dans un plan parallèle au plan des tubes chauds, et dans lesquels circule un fluide froid,

— des thermo-éléments montés entre les susdits tubes chauds et les susdits tubes froids,

— et des moyens de liaison mécanique pour maintenir entre eux les premier et second réseaux de tubes chauds et froids et/ou pour créer une force d'application entre les susdits tubes chauds et froids et les susdits thermo-éléments,

et elle est caractérisée par le fait que ces moyens de liaison mécanique sont essentiellement constitués par :

— au moins deux structures mécaniques de liaison, dites structures chaudes, reliant les tubes chauds, respectivement vers leurs deux extrémités, ces deux structures chaudes étant indépendantes des tubes froids,

— au moins deux structures mécaniques de liaison, dites structures froides, reliant les tubes froids, respectivement vers leurs deux extrémités, ces deux structures froides étant indépendantes des tubes chauds,

— et des dispositifs de fixation, pour rendre solidaires entre elles les structures chaudes et les structures froides situées à une même extrémité.

Les dispositifs de fixation sont avantageusement agencés pour assurer une solidarisation transversale (perpendiculaire aux tubes chauds et froids) et/ou axiale (parallèle aux tubes chauds et/ou froids) des structures chaudes et des structures froides.

L'invention pourra, de toute façon, être bien comprise à l'aide du complément de description qui suit ainsi que des dessins ci-annexés, lesquels complément et dessins sont relatifs à des modes de réalisation préférés de l'invention et ne comportent, bien entendu, aucun caractère limitatif.

La figure 1, de ces dessins, est une vue en coupe schématique d'une installation thermo-électrique établie conformément à un premier mode de réalisation de l'invention.

La figure 2 est une vue en coupe partielle par un plan perpendiculaire à celui de la figure 1.

La figure 3 est une vue en coupe schématique d'une installation thermo-électrique établie conformément à un deuxième mode de réalisation de l'invention.

La figure 4 est une vue en coupe schématique d'une installation thermo-électrique établie conformément à un troisième mode de réalisation de l'invention.

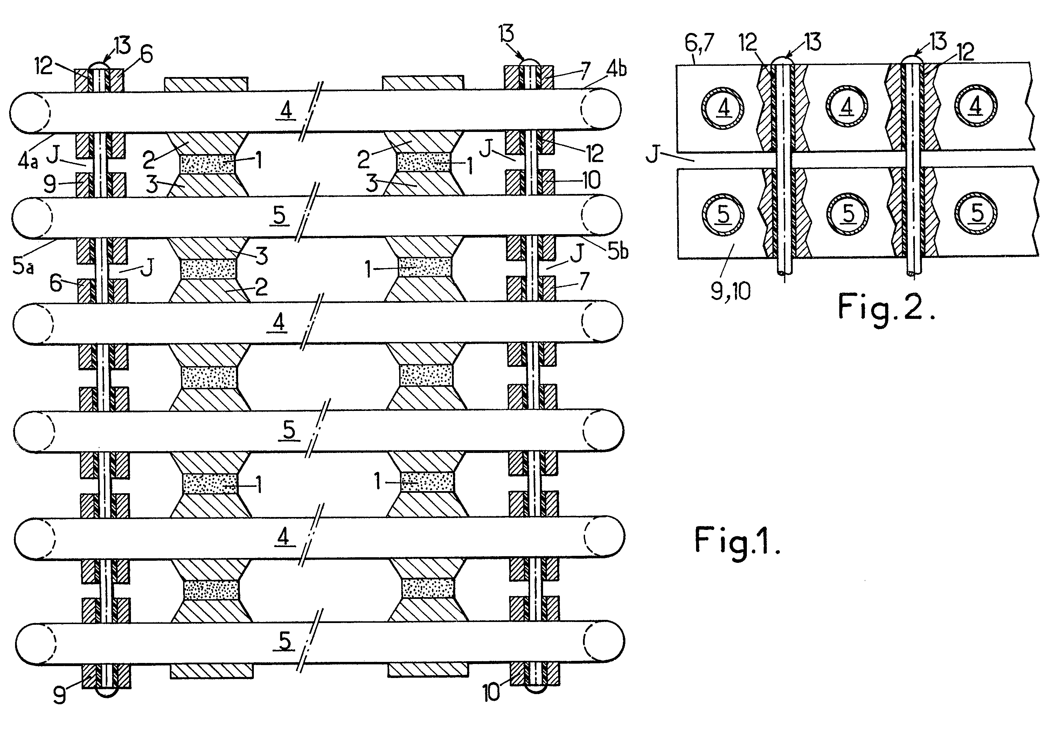

L'installation montrée sur les figures 1 à 4 comporte des thermo-éléments 1, montés entre deux parois d'échanges thermiques, à savoir une paroi d'échanges thermiques. chaude 2 et une paroi d'échanges thermiques froide 3.

L'installation est du type « pompe à chaleur » et les thermo-éléments 1 sont alimentés par une source de courant continu (non représentée) afin de maintenir les faces des thermo-éléments à des températures différentes.

Chaque paroi d'échanges thermiques chaude 2 et froide 3 coopère respectivement avec un tube chaud 4 et avec un tube froid 5.

L'installation comporte donc :

— un premier réseau de tubes chauds 4, s'étendant entre deux extrémités 4a, 4b, disposés de façon parallèle, et dans lesquels circule un fluide chaud,

— un second réseau de tubes froids 5, s'étendant entre deux extrémités 5a, 5b, disposés de façon parallèle et dans un plan parallèle au plan des tubes chauds 4 du premier réseau, et dans lesquels circule un fluide froid.

Les thermo-éléments 1 sont montés entre les susdits tubes chauds 4 et les susdits tubes froids 5, avec interposition des parois d'échanges thermiques chaudes 2 et froides 3 correspondantes.

Des moyens de liaison mécanique sont alors prévus pour maintenir entre eux les premier et second réseaux de tubes chauds 4 et froids 5, et pour créer une force d'application entre les susdits tubes chauds 4 et froids 5 et les susdits thermo-éléments 1.

Ces moyens de liaison mécanique sont essentiellement constitués par :

— au moins deux structures mécaniques de liaison, dites structures chaudes 6, 7, reliant les tubes chauds 4, respectivement vers leurs deux extrémités 4a, 4b, ces deux structures chaudes 6, 7 étant indépendantes des tubes froids 5,

— au moins deux structures mécaniques de liaison, dites structures froides 9, 10, reliant les tubes froids 5, respectivement vers leurs deux extrémités 5a, 5b, ces deux structures froides 9, 10 étant indépendantes des tubes chauds 4,

— et des dispositifs de fixation 13, pour rendre solidaires entre elles les structures chaudes 6, 7 et les structures froides 9, 10 situées à une même extrémité 4a, 5a ou 4b, 5b.

Selon le mode de réalisation de l'invention illustré sur les figures 1 et 2, les dispositifs de fixation 13 sont agencés pour assurer une solidarisation transversale — c'est-à-dire dans un sens perpendiculaire aux tubes chauds 4 et aux tubes froids 5 — des structures chaudes 6, 7 et des structures froides 9, 10.

A cet effet, on peut avoir recours à une construction selon laquelle :

— les structures chaudes 6, 7 sont constituées par des brides chaudes, reliant chacune les tubes d'une nappe de tubes chauds 4,

— les structures froides 9, 10 sont constituées par des brides froides, reliant chacune les tubes d'une nappe de tubes froids 5,

la dimension de ces brides chaudes et froides dans le sens perpendiculaire au plan des tubes étant telle qu'il subsiste un jeu J entre deux brides chaude et froide adjacentes.

Les dispositifs de fixation 13 sont alors constitués par une pluralité de tiges agencées pour traverser les deux successions de brides chaudes et froides qui se trouvent respectivement aux deux extrémités 4a, 5a et 4b, 5b des tubes chauds 4 et des tubes froids 5.

Des dispositifs d'isolation thermique 12 peuvent être interposés entre les dispositifs de fixation 13 et les brides chaudes et froides.

Avantageusement, les brides chaudes 6, 7 et les brides froides 9, 10 peuvent être réalisées sous forme de profilés.

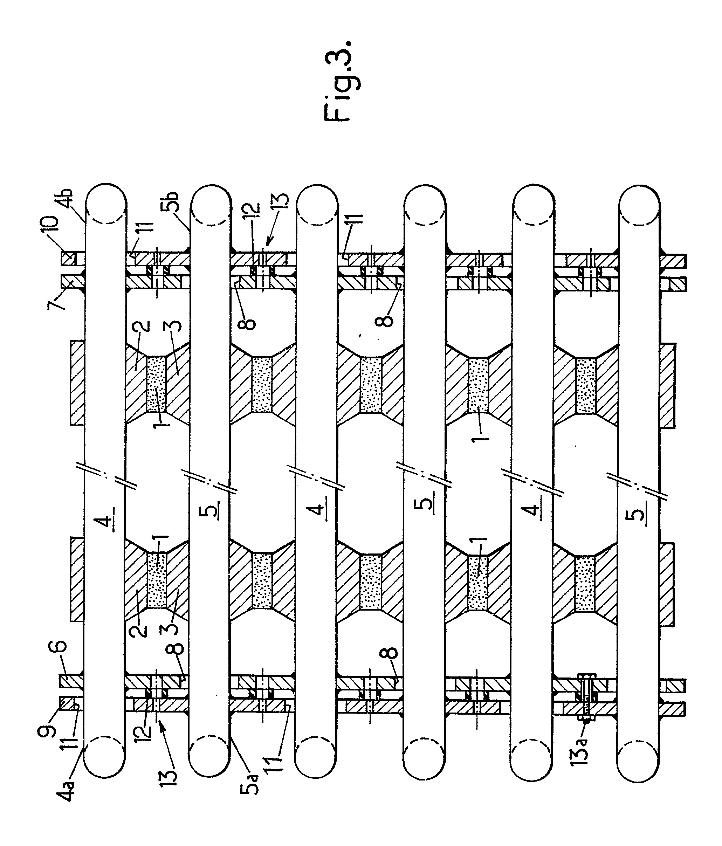

Selon le mode de réalisation de l'invention illustré sur la figure 3, les dispositifs de fixation 13 sont agencés pour assurer une solidarisation axiale — c'est-à-dire dans un sens parallèle aux tubes chauds 4 et/ou aux tubes froids 5 — des structures chaudes 6, 7 et des structures froides 9, 10.

A cet effet, on peut avoir recours à une construction selon laquelle :

— les deux structures chaudes 6, 7 sont constituées par au moins deux plaques chaudes, parallèles entre elles et reliées à chacun des tubes chauds 4 respectivement vers leurs deux extrémités 4a, 4b, ces deux plaques chaudes présentant des orifices 8 qui les rendent indépendantes des tubes froids 5,

— les deux structures froides 9, 10 sont constituées par au moins deux plaques froides, parallèles entre elles et reliées à chacun des tubes froids 5 respectivement vers leurs deux extrémités 5a, 5b, ces deux plaques froides présentant des orifices 11 qui les rendent indépendantes des tubes chauds 4.

Les dispositifs de fixation 13 sont alors agencés pour maintenir les plaques chaudes et froides axialement liées l'une à l'autre.

Avantageusement, les deux plaques froides 9, 10 sont situées plus à l'extérieur que les deux plaques chaudes 6, 7, auquel cas les dispositifs de fixation 13 ont un seul rôle de maintien.

Cependant, les deux plaques chaudes 6, 7 pourraient être situées le plus à l'extérieur par rapport aux deux plaques froides 9, 10 ; dans ce cas, les dispositifs de fixation 13 travaillent en traction et procurent une certaine élasticité à l'ensemble de l'installation.

Ces dispositifs de fixation 13 peuvent avantageusement être constitués par des boulons 13a traversant la plaque chaude 6, 7 et la plaque froide 9, 10. Les trous de passage de ces boulons 13a peuvent être allongés dans la direction selon laquelle les thermo-éléments 1 sont maintenus en appui sur les tubes chauds 4 et les tubes froids 5, soit dans les plaques chaudes, soit dans les plaques froides, soit dans les deux.

Des moyens d'isolation thermique 12 sont interposés entre chaque plaque chaude 6, 7 et chaque plaque froide 9, 10 lui correspondant.

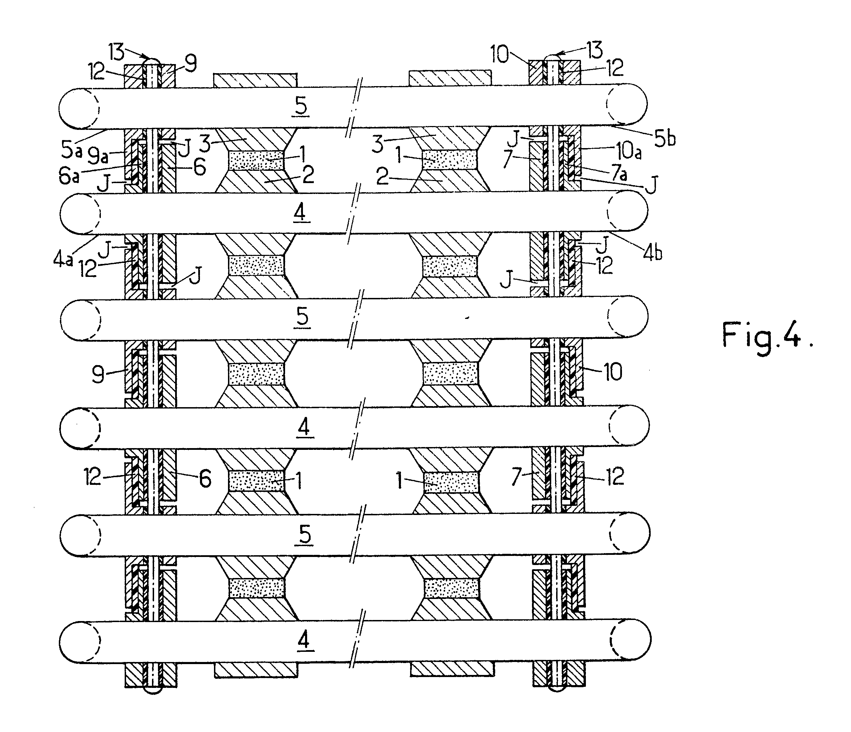

Selon le mode de réalisation de l'invention illustré sur la figure 4, les dispositifs de fixation 13 sont agencés pour assurer une solidarisation transversale (dans le sens perpendiculaire aux tubes chauds 4 et aux tubes froids 5) et axiale (dans le sens parallèle aux tubes chauds 4 et/ou aux tubes froids 5) des structures chaudes 6, 7 et des structures froides 9, 10.

A cet effet, on peut avoir recours à une construction analogue à celle montrée sur la figure 1, les dispositifs de fixation 13, réalisés sous forme de tiges, étant alors agencés pour pouvoir résister au cisaillement et s'opposer aux déplacements axiaux relatifs entre les brides chaudes 6, 7 et les brides froides 9, 10.

Cependant, on peut aussi avoir recours à la construction montrée sur la figure 4 et selon laquelle les brides chaudes 6, 7 présentent des surfaces d'appui 6a, 7a coopérant avec des surfaces de butée 9a, 10a prévues sur les brides froides 9, 10.

Des moyens d'isolation thermique 12 peuvent être interposés entre les dispositifs de fixation 13, réalisés sous forme de tiges, et les brides chaudes 6, 7 et/ou les brides froides 9, 10.

Si l'on prévoit une coopération brides chaudes 6, 7, brides froides 9, 10 par surfaces d'appui 6a, 7a et surfaces de butée 9a, 10a, on peut prévoir entre lesdites surfaces d'appui 6a, 7a et de butée 9a, 10a, d'autres moyens d'isolation thermique 12.

Selon le mode de réalisation illustré sur les figures 1 et 2, l'installation est particulièrement simple car l'espace intérieur occupé par les deux réseaux de tubes chauds et froids est libre de toute structure interne de mise en compression des thermo-éléments. De plus, un agencement particulier des dispositifs de fixation sous forme de tiges résistant au cisaillement permet de s'opposer aux déplacements axiaux relatifs entre les brides chaudes et froides, donc d'éviter les déplacements axiaux relatifs entre tubes chauds et tubes froids, donc d'éviter toute contrainte de cisaillement au niveau des thermo-éléments.

Selon le mode de réalisation de l'invention illustré sur la figure 3, la coopération des plaques chaudes et des plaques froides entre elles permet également de s'opposer aux déplacements axiaux relatifs entre tubes chauds et tubes froids, donc d'éviter toute contrainte de cisaillement au niveau des thermo-éléments.

Selon le mode de réalisation de l'invention illustré sur la figure 4, on obtient les avantages combinés des modes de réalisation des figures 1 et 2 et de la figure 3 : absence de toute structure interne de mise en compression des thermo-éléments, et coopération entre elles des brides chaudes et froides évitant toute contrainte de cisaillement au niveau des thermo-éléments.

De toute façon et quel que soit le mode de réalisation, l'installation présente en outre les avantages suivants : risques de fuite des fluides chauds et froids éliminés ; pertes de charge sur les fluides chauds et froids réduites ; obtention de résistances thermiques faibles et constantes dans le temps ; construction et montage simples ; réalisation peu coûteuse.

Par ailleurs, il est possible de réaliser des installations du type à tubes chauds et froids parallèles (correspondant aux modes de réalisation illustrés sur les figures 1 à 4) ou des installations du type à tubes croisés, c'est-à-dire à tubes chauds orthogonaux aux tubes froids, tout en restant dans des plans parallèles (installation non représentée).

**Revendications**

1. Installation thermo-électrique comportant :

— un premier réseau de tubes chauds (4) s'étendant entre deux extrémités (4a, 4b), disposés de façon parallèle, et dans lesquels circule un fluide chaud,

— un second réseau de tubes froids (5), s'étendant entre deux extrémités (5a, 5b), disposés de façon parallèle et dans un plan parallèle au plan des tubes chauds (4), et dans lesquels circule un fluide froid,

— des thermo-éléments (1) montés entre les susdits tubes chauds (4) et les susdits tubes froids (5),

— et des moyens de liaison mécanique (6, 7, 9, 10, 13) pour maintenir entre eux les premier et second réseaux de tubes chauds (4) et froids (5) et/ou pour créer une force d'application entre les susdits tubes chauds (4) et froids (5) et les susdits thermo-éléments (1),

caractérisée par le fait que ces moyens de liaison mécanique (6, 7, 9, 10, 13) sont essentiellement constitués par :

— au moins deux structures mécaniques de liaison, dites structures chaudes (6, 7), reliant les tubes chauds (4), respectivement vers leurs deux extrémités (4a, 4b), ces deux structures chaudes (6, 7) étant indépendantes des tubes froids (5),

— au moins deux structures mécaniques de liaison, dites structures froides (9, 10), reliant les tubes froids (5), respectivement vers leurs deux extrémités (5a, 5b), ces deux structures froides (9, 10) étant indépendantes des tubes chauds (4),

— et des dispositifs de fixation (13), pour rendre solidaires entre elles les structures chaudes (6, 7) et les structures froides (9, 10), situées à une même extrémité (4a, 5a) ou (4b, 5b).

2. Installation selon la revendication 1, caractérisée par le fait que les dispositifs de fixation (13) sont agencés pour assurer une solidarisation transversale (perpendiculaire aux tubes chauds et aux tubes froids) des structures chaudes (6, 7) et des structures froides (9, 10).

3. Installation selon la revendication 1, caractérisée par le fait que les dispositifs de fixation (13) sont agencés pour assurer une solidarisation axiale (parallèle aux tubes chauds et/ou aux tubes froids) des structures chaudes (6, 7) et des structures froides (9, 10).

4. Installation selon la revendication 1, caractérisée par le fait que les dispositifs de fixation (13) sont agencés pour assurer une solidarisation transversale (perpendiculaire aux tubes chauds et aux tubes froids) et axiale (parallèle aux tubes chauds et/ou aux tubes froids) des structures chaudes (6, 7) et des structures froides (9, 10).

5. Installation selon la revendication 2, caractérisée par le fait que :

— les structures chaudes (6, 7) sont constituées par des brides chaudes, reliant chacune les tubes d'une nappe de tubes chauds (4),

— les structures froides (9, 10) sont constituées par des brides froides, reliant chacune les tubes d'une nappe de tubes froids (5),

— la dimension de ces brides chaudes et froides dans le sens perpendiculaire au plan des tubes étant telle qu'il subsiste un jeu (J) entre deux brides chaude et froide adjacentes,

— les dispositifs de fixation (13) étant constitués par une pluralité de tiges agencées pour traverser les deux successions de brides chaudes et froides qui se trouvent respectivement aux deux extrémités (4a, 5a et 4b, 5b) des tubes chauds (4) et des tubes froids (5).

6. Installation selon la revendication 5, caractérisée par le fait que les brides chaudes et froides sont réalisées sous forme de profilés.

7. Installation selon l'une quelconque des revendications 4 à 6, caractérisée par le fait que les dispositifs de fixation (13) sous forme de tiges sont agencés pour pouvoir résister au cisaillement et s'opposer aux déplacements axiaux relatifs entre les brides chaudes (6, 7) et les brides froides (9, 10).

8. Installation selon l'une quelconque des revendications 4 à 6, caractérisée par le fait que les brides chaudes (6, 7) présentent des surfaces d'appui (6a, 7a) coopérant avec des surfaces de butée (9a, 10a) prévues sur les brides froides (9, 10).

9. Installation selon la revendication 7, caractérisée par le fait que des moyens d'isolation thermique (12) sont interposés entre les dispositifs de fixation (13) sous forme de tiges et les brides chaudes (6, 7) et/ou les brides froides (9, 10).

10. Installation selon la revendication 9, caractérisée par le fait que des moyens d'isolation thermique (12) sont interposés entre les surfaces d'appui (6a, 7a) et de butée (9a, 10a).

11. Installation selon la revendication 3, caractérisée par le fait que :

— les deux structures chaudes sont constituées par au moins deux plaques chaudes (6, 7), parallèles entre elles et reliées à chacun des tubes chauds (4) respectivement vers leurs deux extrémités (4a, 4b), ces deux plaques chaudes (6, 7) présentant des orifices (8) qui les rendent indépendantes des tubes froids (5),

— les deux structures froides sont constituées par au moins deux plaques froides (9, 10), parallèles entre elles et reliées à chacun des tubes froids (5) respectivement vers leurs deux extrémités (5a, 5b), ces deux plaques froides (9, 10) présentant des orifices (11) qui les rendent indépendantes des tubes chauds (4).

12. Installation selon la revendication 3 ou 11, caractérisée par le fait que les dispositifs de fixation (13) sont prévus entre chaque structure chaude (6, 7) et chaque structure froide (9, 10) pour les maintenir axialement liées l'une à l'autre.

13. Installation selon la revendication 12, caractérisée par le fait que les dispositifs de fixation (13) sont constitués par des boulons (13a) traversant la plaque chaude (6, 7) et la plaque froide (9, 10), et par le fait que les trous de passage de ces boulons (13a) sont allongés dans la direction selon laquelle les thermo-éléments (1) sont maintenus en appui sur les tubes chauds (4) et les tubes froids (5), soit dans les plaques chaudes, soit dans les plaques froides, soit dans les deux.

## Claims

1. Thermo-electric installation comprising :

— A first system of hot tubes (4) extending between two ends (4a, 4b) and arranged parallel to each other and through which a hot fluid circulates,

— a second system of cold tubes (5) extending between two ends (5a, 5b) and arranged parallel to each other and in a plane parallel to the plane of the hot tubes (4), and through which a cold fluid circulates,

— thermo-elements (1) mounted between the said hot tubes (4) and the said cold tubes (5),

— and mechanical connecting means (6, 7, 9, 10, 13) to support between them the first and second system of hot (4) and cold (5) tubes and/or to produce a force of application between the said hot (4) and cold (5) tubes and the said thermo-elements (1),

characterised by the fact that these mechanical connecting means (6, 7, 9, 10, 13) essentially comprise :

— at least two mechanical connecting structures referred to as hot structures (6, 7) connecting the hot tubes (4) respectively at their two ends (4a, 4b), these two hot structures (6, 7) being independent of the cold tubes (5),

— at least two mechanical connecting structures referred to as cold structures (9, 10) connecting the cold tubes (5) respectively at their two ends (5a, 5b), these two cold structures (9, 10) being independent of the hot tubes (4),

— and fastening means (13) to fasten together the hot structures (6, 7) and cold structures (9, 10) situated at one and the same end (4a, 5a) or (4b, 5b).

2. Installation according to claim 1, characterised by the fact that the fastening means (13) are arranged to provide a firm transverse connection (perpendicularly to the hot tubes and to the cold tubes) of the hot structures (6, 7) and the cold structures (9, 10).

3. Installation according to claim 1, characterised by the fact that the fastening means (13) are arranged to provide an axial connection (parallel to the hot tubes and/or to the cold tubes) between the hot structures (6, 7) and the cold structures (9, 10).

4. Installation according to claim 1, characterised by the fact that the fastening means (13) are arranged to provide a transverse connection (perpendicularly to the hot tubes and to the cold tubes) and an axial connection (parallel to the hot tubes and/or to the cold tubes) between the hot structures (6, 7) and the cold structures (9, 10).

5. Installation according to claim 2, characterised by the fact that

— the hot structures (6, 7) consist of hot clamps connecting all the tubes of a layer of hot tubes (4),

— the cold structures (9, 10) consist of cold clamps connecting all the tubes of a layer of cold tubes (5),

— the dimension of these hot and cold clamps in the direction perpendicular to the plane of the tubes being such as to leave a clearance (J) between two adjacent hot and cold clamps,

— the fastening means (13) consisting of a plurality of rods arranged to traverse the two successions of hot and cold clamps situated, respectively, at the two ends (4a, 5a and 4b, 5b) of the hot tubes (4) and cold tubes (5).

6. Installation according to claim 5, characterised by the fact that the hot and cold clamps are in the form of profiled sections.

7. Installation according to any one of claims 4 to 6, characterised by the fact that the fastening means (13) in the form of rods are arranged to be able to resist shearing and oppose relative axial displacements between the hot clamps (6, 7) and the cold clamps (9, 10).

8. Installation according to any one of claims 4 to 6, characterised by the fact that the hot clamps (6, 7) have bearing surfaces (6a, 7a) cooperating with abutment surfaces (9a, 10a) provided on the cold clamps (9, 10).

9. Installation according to claim 7, characterised by the fact that thermal insulating means (12) are interposed between the fastening means (13) in the form of rods and the hot clamps (6, 7) and/or the cold clamps (9, 10).

10. Installation according to claim 9, characterised by the fact that the thermal insulating means (12) are interposed between the bearing surfaces (6a, 7a) and the abutment surfaces (9a, 10a).

11. Installation according to claim 3, characterised by the fact that :

— the two hot structures comprise at least two hot plates (6, 7) parallel to each other and connected to each of the hot tubes (4) at their two respective ends (4a, 4b), these two hot plates (6, 7) having orifices (8) which render them independent of the cold tubes (5),

— the two cold structures comprise at least two cold plates (9, 10) parallel to each other and connected to each of the cold tubes (5) at their two respective ends (5a, 5b), these two cold plates (9, 10) having orifices (11) which render them independent of the hot tubes (4).

12. Installation according to claim 3 or claim 11, characterised by the fact that the fastening means (13) are provided between each hot structure (6, 7) and each cold structure (9, 10) to keep them axially connected to one another.

13. Installation according to claim 12, characterised by the fact that the fastening means (13) comprise bolts (13a) traversing the hot plate (6, 7) and the cold plate (9, 10), and by the fact that the bores for the passage of these bolts (13a) extend in the direction in which the thermo-elements (1) are held against the hot tubes (4) and cold tubes (5), either in the hot plates or in the cold plates or in both.

**Ansprüche**

1. Thermoelektrische Anlage mit :
— einem ersten Bündel von warmen Rohren (4), die sich zwischen zwei Enden (4a, 4b) erstrecken, parallel zueinander angeordnet sind und in denen ein warmes Fluid strömt,

— einem zweiten Bündel von kalten Rohren (5), die sich zwischen zwei Enden (5a, 5b) erstrecken, parallel zueinander in einer zur Ebene der warmen Rohre (4) parallelen Ebene angeordnet sind und in denen ein kaltes Fluid strömt,

— Thermoelementen (1), die zwischen den warmen Rohren (4) und den kalten Rohren (5) montiert sind,

— und mechanischen Verbindungsmitteln (6, 7, 9, 10, 13), welche das erste und das zweite Bündel von warmen Rohren (4) bzw. von kalten Rohren (5) untereinander halten und/oder eine Anlagekraft zwischen den warmen Rohren (4) und den kalten Rohren (5) sowie den Thermoelementen (1) erzeugen,
dadurch gekennzeichnet, daß die mechanischen Verbindungsmittel (6, 7, 9, 10, 13) im wesentlichen gebildet sind durch :

— zumindest zwei mechanische Verbindungsanordnungen, u. zw. warme Anordnungen (6, 7), welche die warmen Rohre (4) an deren beiden Enden (4a, 4b) verbinden, wobei die beiden warmen Anordnungen (6, 7) unabhängig von den kalten Rohren (5) sind,

— zumindest zwei mechanische Verbindungsanordnungen (9, 10), welche die kalten Rohre (5) an deren beiden Enden (5a, 5b) verbinden, wobei diese beiden Anordnungen (9, 10) unabhängig von den warmen Rohren sind,

— und Befestigungseinrichtungen (13), welche die warmen Anordnungen (6, 7) und die kalten Anordnungen (9, 10) untereinander fixieren und an ein und demselben Ende (4a, 5a) bzw. (4b, 5b) angeordnet sind.

2. Anlage nach Anspruch 1, dadurch gekennzeichnet, daß die Befestigungseinrichtungen (13) so angeordnet sind, daß sie eine Querbefestigung (senkrecht zu den warmen Rohren und den kalten Rohren) der warmen Anordnungen (6, 7) und der kalten Anordnungen (9, 10) gewährleisten.

3. Anlage nach Anspruch 1, dadurch gekennzeichnet, daß die Befestigungseinrichtungen (13) so angeordnet sind, daß sie eine Axialbefestigung (parallel zu den warmen Rohren und/oder den kalten Rohren) der warmen Anordnungen (6, 7) und den kalten Anordnungen (9, 10) gewährleisten.

4. Anlage nach Anspruch 1, dadurch gekennzeichnet, daß die Befestigungseinrichtungen (13) so angeordnet sind, daß sie eine Querbefestigung (senkrecht zu den warmen Rohren und zu den kalten Rohren) und eine Axialbefestigung (parallel zu den warmen Rohren und/oder zu den kalten Rohren) der warmen Anordnungen (6, 7) und den kalten Anordnungen (9, 10) gewährleisten.

5. Anlage nach Anspruch 2, dadurch gekennzeichnet, daß

— die warmen Anordnungen (6, 7) durch warme Bügel gebildet sind, die je die Rohre einer Schar von warmen Rohren (4) verbinden,

— die kalten Anordnungen (9, 10) durch kalte Bügel gebildet sind, die je die Rohre einer Schar von kalten Rohren (5) verbinden,

— die Abmessung der warmen Bügel und der kalten Bügel in Richtung senkrecht zur Ebene der Rohre so gewählt ist, daß zwischen einander benachbarten warmen und kalten Bügeln ein Spiel (J) vorhanden ist,

— die Befestigungseinrichtungen (13) durch eine Vielzahl von Stangen gebildet sind, die so angeordnet sind, daß sie die beiden Reihen von warmen Bügeln und kalten Bügeln durchsetzen, die sich an den beiden Enden (4a, 5a und 4b, 5b) der warmen Rohre und der kalten Rohre befinden.

6. Anlage nach Anspruch 5, dadurch gekennzeichnet, daß die warmen Bügel und die kalten Bügel in Form von Profilen ausgebildet sind.

7. Anlage nach einem der Ansprüche 4 bis 6, dadurch gekennzeichnet, daß die Befestigungseinrichtungen (13) in Form von Stangen so angeordnet sind, daß sie einer Scherbeanspruchung widerstehen und relativen Axialverlagerungen zwischen den warmen Bügeln (6, 7) und den kalten Bügeln (9, 10) entgegenwirken.

8. Anlage nach einem der Ansprüche 4 bis 6, dadurch gekennzeichnet, daß die warmen Bügel (6, 7) Anlageflächen (6a, 7a) aufweisen, die mit auf den kalten Bügeln (9, 10) ausgebildeten Anschlagflächen (9a, 10a) zusammenwirken.

9. Anlage nach Anspruch 7, dadurch gekennzeichnet, daß die Wärmeisoliermittel (12) zwischen den in Form von Stangen ausgebildeten Befestigungseinrichtungen (13) und den warmen Bügeln (6, 7) und/oder den kalten Bügeln (9, 10) angeordnet sind.

10. Anlage nach Anspruch 9, dadurch gekennzeichnet, daß Wärmeisoliermittel (12) zwischen den Anlageflächen (6a, 7a) und den Anschlagflächen (9a, 10a) vorgesehen sind.

11. Anlage nach Anspruch 3, dadurch gekennzeichnet, daß

— die beiden warmen Anordnungen durch zumindest zwei warme Platten (6, 7) gebildet sind, die zueinander parallel und mit jedem der warmen Rohre (4) deren beiden Enden verbunden sind, wobei die warmen Platten (6, 7) Öffnungen (8) aufweisen, die sie von den kalten Rohren (5) unabhängig machen,

— die beiden kalten Anordnungen durch zumindest zwei kalte Platten (9, 10) gebildet sind, die zueinander parallel und mit jedem der kalten Rohre (5) an deren beiden Ende (5a, 5b) verbunden sind, wobei die kalten Platten (9, 10) Öffnungen (11) aufweisen, die sie von den warmen Rohren (4) unabhängig machen.

12. Anlage nach Anspruch 3 oder 11, dadurch gekennzeichnet, daß die Befestigungseinrichtungen (13) zwischen jeder warmen Anordnung (6, 7) und jeder kalten Anordnung (9, 10) vorgesehen sind, um sie axial miteinander zu verbinden.

13. Anlage nach Anspruch 12, dadurch gekennzeichnet, daß die Befestigungseinrichtungen (13) durch Bolzen (13a) gebildet sind, welche die warme Platte (6, 7) und die kalte Platte (9, 10) durchsetzen, und daß die Durchtrittsöffnungen der Bolzen (13a) in jener Richtung, in welcher die Thermoelemente (1) an den warmen Rohren (4) und an den kalten Rohren (5) in Anlage gehalten sind, vergrößert sind, entweder in den warmen Platten oder in den kalten Platten oder in beiden.

Fig.2.

Fig.1.

Fig.3.

0 055 175

Fig.4.